# EUROPEAN PATENT APPLICATION

(11) **EP 4 084 241 A1**
(43) Date of publication of application: **02.11.2022**
(21) Application number: 20907763.5
(22) Date of filing: 15.12.2020
(51) Int. Cl.: H01S 5/024

(54) **LASER DEVICE**

(30) Priority: 23.12.2019 JP 2019231604
(71) Applicant: Panasonic Intellectual Property Management Co., Ltd., Osaka-shi, Osaka 540-6207 (JP)
(72) Inventor: HISHIDA, Mitsuoki, Osaka-shi, Osaka 540-6207 (JP)
(74) Representative: Novagraaf International SA
(86) International application number: PCT/JP2020/046646
(87) International publication number: WO 2021/131883

(57) **Abstract**

First block (10) is provided with heat dissipator (50). Heat dissipator (50) is provided at an end part of first block (10) on the emission side of the laser light. Heat dissipator (50) extends forward beyond a light emitting surface of semiconductor laser element (40). The surface, of heat dissipator (50), facing the laser light is inclined so as to be more distant from center line L of the laser light toward the forward direction.

## Description

### TECHNICAL FIELD

The present disclosure relates to a laser device.

### BACKGROUND ART

PTL 1 discloses a semiconductor laser device in which a first electrode block, a submount, an insulating layer, a semiconductor laser element, bumps, and a second electrode block are stacked.

In the semiconductor laser element, when a current flows from the anode toward the cathode, laser light is output from the light emitting surface. The electrode blocks are mainly made of copper, and the heat generated in the semiconductor laser element is dissipated from the electrode blocks.

### Citation List

### Patent Literature

PTL 1: International Publication No. WO 2016/103536

### SUMMARY OF THE INVENTION

### Technical problem

When the semiconductor laser element is heated to high temperatures, there is a possibility that there occurs performance deterioration such as a decrease in laser output. To address this issue, it is demanded to efficiently dissipate the heat generated in the semiconductor laser element to stabilize the performance of the semiconductor laser element.

The present disclosure has been made in view of such a point, and an object of the disclosure is to efficiently dissipate the heat generated in a semiconductor laser element. Solutions to problem

The present disclosure is directed to a laser device including a semiconductor laser element that emits laser light, and the following solutions have been taken.

A first invention includes: a first block electrically connected to a first electrode of a semiconductor laser element; a second block electrically connected to a second electrode on an opposite side of the semiconductor laser element with respect to the first electrode, and a heat dissipator provided on an end part, of at least one of the first block and the second block, on an emission side of the laser light, the heat dissipator extending in a forward direction in an emission direction beyond a light emitting surface of the semiconductor laser element. A surface, of the heat dissipator, facing the laser light is an inclined surface that is inclined to be more distant from a center line of the laser light toward the forward direction, the inclined surface of the heat dissipator has an inclination angle a that is equal to a spread angle b with respect to the center line of the laser light or greater than the spread angle b, and the heat dissipator has, in plan view, a lacking portion, on at least one side in a width direction, on a forward side in the emission direction of the laser light.

In the first invention, the heat dissipator is provided at the end part, of at least one of the first block and the second block, on the emission side of the laser light. By providing the heat dissipator on at least one of the first block and the second block in this manner, the surface area of the block can be increased. As a result, the heat generated in the semiconductor laser element can be efficiently dissipated from the heat dissipator.

The heat dissipator extends forward beyond the light emitting surface of the semiconductor laser element. In addition, the surface, of the heat dissipator, facing the laser light is inclined to be more distant from the center line of the laser light toward the forward direction.

This configuration can prevent or reduce blocking, by the heat dissipator, of the laser light that is emitted from the light emitting surface of the semiconductor laser element and radially spreads.

The inclination angle a of the inclined surface of the heat dissipator is set to be equal to the spread angle b of the laser light with respect to the center line or greater than the spread angle b. This configuration can prevent or reduce blocking, by the heat dissipator, of the laser light that is emitted from the semiconductor laser element and radially spreads from the light emitting surface.

The heat dissipator has, in plan view, the lacking portion, on at least one side in the width direction, on the forward side in the emission direction of the laser light.

This makes it possible, when a plurality of laser devices are arranged so as to combine laser light, to prevent or reduce interference between the heat dissipators of the neighboring laser devices.

It is also possible to dissipate the heat generated in the semiconductor laser elements, relatively effectively from the central sides of the heat dissipators.

A second invention is configured such that, in the first invention, the heat dissipator is formed, in plan view, in a line-symmetric shape with respect to the center line of the laser light.

In the second invention, the heat dissipator is formed to have, in plan view, a line-symmetric shape with respect to the center line of the laser light. As a result, the heat generated in the semiconductor laser element can be efficiently dissipated from the heat dissipator.

A third invention is configured such that, in the first invention, the heat dissipator is formed, in plan view, in a non-line-symmetric shape with respect to the center line of the laser light.

In the third invention, the heat dissipator is formed to have, in plan view, a non-line-symmetric shape with respect to the center line of the laser light. This makes it possible, when a plurality of laser devices are arranged so as to combine laser light (for example, wavelength combination, spatial combination, and polarization combination of laser light), to prevent or reduce interference between the heat dissipators of the neighboring laser devices.

A fourth invention is configured such that, in any one of the first to third inventions, a substantially central part, in plan view, of a front end edge of the heat dissipator in a width direction orthogonal to the center line of the laser light protrudes forward beyond end parts, of the front end edge, in the width direction.

In the fourth invention, the front end edge of the heat dissipator has a shape in which a substantially central part in the width direction orthogonal to the center line of the laser light protrudes, in plan view, forward beyond the end parts.

As a result, the heat generated in the semiconductor laser element can be efficiently dissipated from a central portion of the heat dissipator.

Since the central portion of the heat dissipator protrudes forward, the end parts of the heat dissipator are cut off. This makes it possible, when a plurality of laser devices are arranged so as to combine laser light, to prevent or reduce interference between the heat dissipators of the neighboring laser devices.

A fifth invention is configured as follows in any one of the first to fourth inventions. The heat dissipator includes: a first heat dissipator; and a second heat dissipator provided further forward in the emission direction than the first heat dissipator, and the second heat dissipator includes a plurality of fin portions that are each formed in a plate shape and are arranged at intervals in a plate thickness direction.

In the fifth invention, the heat dissipator includes the first heat dissipator and the second heat dissipator. The second heat dissipator is provided further forward in the emission direction than the first heat dissipator. The second heat dissipator includes a plurality of fin portions that are formed in a plate shape and are arranged at intervals in the plate thickness direction of the plurality of fin portions.

By providing the plurality of fin portions in this manner, the surface area of the second heat dissipator can be increased. As a result, the heat generated in the semiconductor laser element can be efficiently dissipated from the first heat dissipator and the second heat dissipator.

A sixth invention is configured such that, in any one of the first to fifth inventions, a front end edge of the heat dissipator is formed, in plan view, in a shape along a concentric circle with an emission position of the laser light on the light emitting surface as the center.

In the sixth invention, the front end edge of the heat dissipator has, in plan view, a shape along a concentric circle with the emission position of the laser light on the light emitting surface as the center.

As a result, the heat generated in the semiconductor laser element can be efficiently dissipated from the heat dissipator.

Specifically, the heat generated in the semiconductor laser element is released in a radial shape with the light emitting surface as the center. Therefore, when the front end edge of the heat dissipator has, in plan view, a shape along a concentric circle with the emission position of the laser light on the light emitting surface as the center, the area of the heat dissipator can be minimized without reducing heat dissipation efficiency.

A seventh invention is configured as follows. In at least one of the first to sixth inventions, on an end part, of at least one of the first block and the second block, on an opposite side to the emission side of the laser light, there is provided a rear heat dissipator that extends backward from the end part on the opposite side.

In the seventh invention, the rear heat dissipator is provided at the end part, of at least one of the first block and the second block, on the opposite side to the emission side of the laser light. This can increase the surface area of the block.

### Advantageous effect of invention

The present disclosure makes it possible to efficiently dissipate the heat generated in a semiconductor laser element.

### BRIEF DESCRIPTION OF THE DRAWINGS

Fig. 1 is a perspective view illustrating a configuration of a laser device according to the first exemplary embodiment.
Fig. 2 is a plan view illustrating the configuration of the laser device.
Fig. 3 is a cross-sectional view taken along line A-A in Fig. 2.
Fig. 4 is a side view illustrating the configuration of the laser device.
Fig. 5 is a plan view illustrating a configuration of a laser device according to the second exemplary embodiment.
Fig. 6A is a plan view illustrating how heat dissipators interfere with each other when a plurality of laser devices are arranged.
Fig. 6B is a plan view illustrating how interference between heat dissipators is avoided when a plurality of laser devices are arranged.
Fig. 7 is a plan view illustrating a configuration of a laser device according to a first variation of the second exemplary embodiment.
Fig. 8 is a plan view illustrating a configuration of a laser device according to a second variation of the second exemplary embodiment.
Fig. 9 is a plan view illustrating a configuration of a laser device according to a third variation of the second exemplary embodiment.
Fig. 10 is a plan view illustrating a configuration of a laser device according to the third exemplary embodiment.
Fig. 11A is a plan view illustrating how heat dissipators interfere with each other when a plurality of laser devices are arranged.
Fig. 11B is a plan view illustrating how interference between heat dissipators is avoided when a plurality of laser devices are arranged.
Fig. 12 is a plan view illustrating a configuration of a laser device according to a first variation of the third exemplary embodiment.
Fig. 13 is a plan view illustrating a configuration of a laser device according to a second variation of the third exemplary embodiment.
Fig. 14 is a plan view illustrating a configuration of a laser device according to the fourth exemplary embodiment.

### DESCRIPTION OF EMBODIMENTS

Hereinafter, exemplary embodiments of the present disclosure will be described with reference to the drawings. The following descriptions of the preferable exemplary embodiments are merely examples in nature, and are not intended to limit the present disclosure, its application, or its use.

### «First exemplary embodiment»

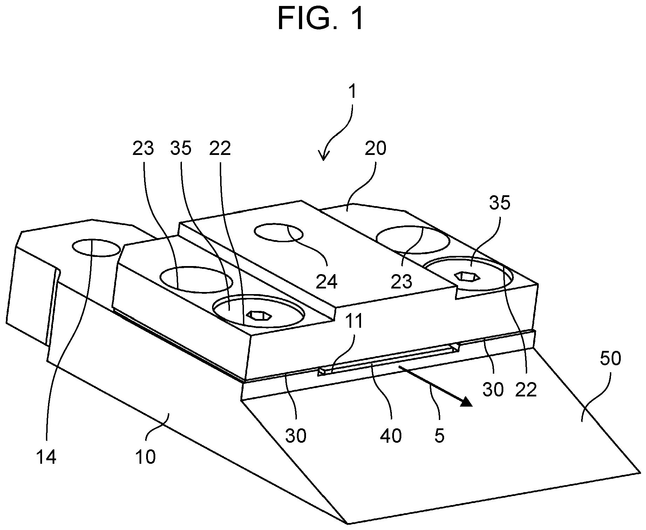

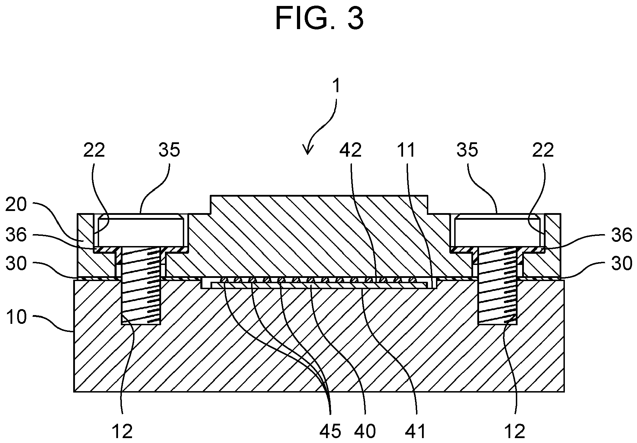

As illustrated in Figs. 1 to 3, laser device 1 has first block 10, second block 20, insulating layer 30, semiconductor laser element 40, and bumps 45.

First block 10 has conductivity. First block 10 is mainly made of copper (Cu). In first block 10, nickel (Ni) and gold (Au) are sequentially plated on a block made of copper.

Recess 11 is provided in an end part of an upper surface of first block 10 on the side of the emission direction 5 of laser light (the direction indicated by the arrow line in Fig. 1). In recess 11 there is provided semiconductor laser element 40. Laser light is radiated in emission direction 5 from semiconductor laser element 40.

First block 10 is provided with first bolt holes 12, second bolt holes 13, and first terminal hole 14. A female thread is formed in each of first bolt holes 12 and second bolt holes 13. Two first bolt holes 12 are provided at an interval in a direction orthogonal to emission direction 5 of the laser light. Between two first bolt holes 12 there is provided recess 11.

Two second bolt holes 13 are provided at an interval in a direction orthogonal to emission direction 5 of the laser light. Second bolt holes 13 are provided on the opposite side of first bolt holes 12 to emission direction 5 of the laser light.

First terminal hole 14 is provided in an end part on the opposite side of first block 10 to emission direction 5 of the laser light. That is, first terminal hole 14 is provided on the end side of first block 10 opposite to recess 11. First terminal hole 14 is a bolt hole. A power supply connecting terminal is connected to first terminal hole 14.

Insulating layer 30 has insulating properties. Insulating layer 30 is made of polyimide, ceramic, or the like. Insulating layer 30 is disposed on the upper surface of first block 10 so as to surround recess 11.

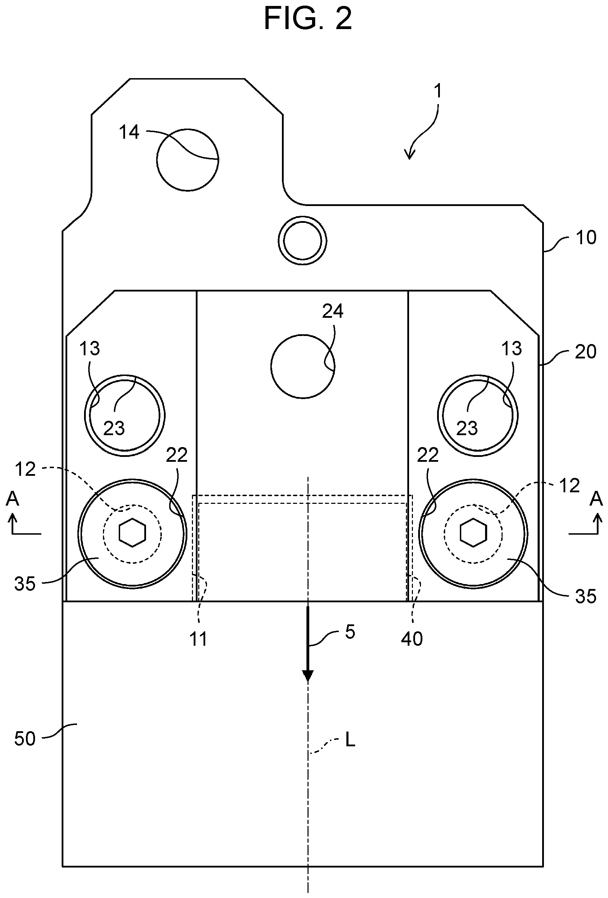

The lower surface of semiconductor laser element 40 is anode 41 (first electrode), and the upper surface is a cathode 42 (second electrode). In semiconductor laser element 40, when a current flows from anode 41 toward cathode 42, laser light is output from a light emitting surface (lower surface in Fig. 2).

Semiconductor laser element 40 is disposed in recess 11. The light emitting surface of semiconductor laser element 40 coincides with side surfaces of recess 11 of first block 10. Anode 41 of semiconductor laser element 40 is electrically connected to first block 10. First block 10 has a function as an electrode block electrically connected to anode 41 of semiconductor laser element 40.

Bumps 45 have conductivity. Bumps 45 are mainly made of gold (Au). The plurality of bumps 45 are provided on cathode 42 of semiconductor laser element 40.

The bumps 45 are each joined to cathode 42 by bringing a gold wire whose tip is made spherical by melting into contact with cathode 42 and by applying an ultrasonic wave to the gold wire. Bumps 45 are electrically connected to cathode 42 of semiconductor laser element 40.

Second block 20 has conductivity. Second block 20 is mainly made of copper (Cu). In second block 20, nickel (Ni) and gold (Au) are sequentially plated on the block made of copper.

Second block 20 is provided on semiconductor laser element 40 and insulating layer 30. Second block 20 is electrically connected to semiconductor laser element 40 via the bumps 45. Second block 20 has a function as an electrode block electrically connected to cathode 42 of semiconductor laser element 40.

Second block 20 is adhered to insulating layer 30 on a region that is the lower surface of second block 20 and is an area other than the region facing semiconductor laser element 40.

Second block 20 is provided with first through holes 22, second through holes 23, and second terminal hole 24. First through holes 22 are provided at the positions corresponding to first bolt holes 12 of first block 10. First through holes 22 are formed as counterbored holes into which the heads of conductive bolts 35 for fastening first block 10 and second block 20 to each other can enter.

Second through holes 23 are provided at the positions corresponding to second bolt holes 13 of first block 10.

Second terminal hole 24 is provided in a central part of second block 20. A power supply connecting terminal is connected to second terminal hole 24.

The depth (height) of recess 11 is set in consideration of the thickness of each of semiconductor laser element 40, bumps 45, and insulating layer 30.

First block 10 and second block 20 are fastened to each other by conductive bolts 35. Conductive bolts 35 are inserted into first through holes 22 of second block 20 and first bolt holes 12 of first block 10.

Insulating members 36 are provided between conductive bolts 35 and second block 20. As a result, first block 10 and second block 20 are prevented from being electrically connected to each other. This makes it possible to fasten first block 10 and second block 20 to each other in a state of not being electrically connected to each other.

In addition, insulating bolts (not shown) are used to fasten first block 10 and second block 20 to each other in a state of being electrically insulated from each other. The insulating bolts are inserted into second through holes 23 of second block 20 and second bolt holes 13 of first block 10.

Instead of the insulating bolts, conductive bolts 35 and insulating members 36 may be used. Alternatively, insulating bolts may be used instead of conductive bolts 35 and insulating members 36.

In laser device 1 having such a configuration, when a current flows from anode 41 toward cathode 42 of semiconductor laser element 40, laser light is output in emission direction 5 of the laser light from the light emitting surface on a side surface of semiconductor laser element 40. At this time, the heat generated in semiconductor laser element 40 is transferred to first block 10 and second block 20.

Incidentally, when semiconductor laser element 40 is heated to high temperatures, there is a possibility that performance deterioration such as a decrease in laser output occurs. To address this issue, it is demanded to efficiently transfer and dissipate the heat generated in semiconductor laser element 40 to stabilize the performance of semiconductor laser element 40.

Therefore, laser device 1 of the present exemplary embodiment has such a structure that can dissipate more efficiently the heat generated in semiconductor laser element 40.

Specifically, first block 10 is provided with heat dissipator 50. Heat dissipator 50 is provided at an end part of first block 10 on the emission side of the laser light. Heat dissipator 50 extends forward in the emission direction beyond the light emitting surface of semiconductor laser element 40.

By providing heat dissipator 50 in first block 10 in this manner, the surface area of first block 10 can be increased. As a result, the heat generated in semiconductor laser element 40 can be efficiently dissipated from heat dissipator 50.

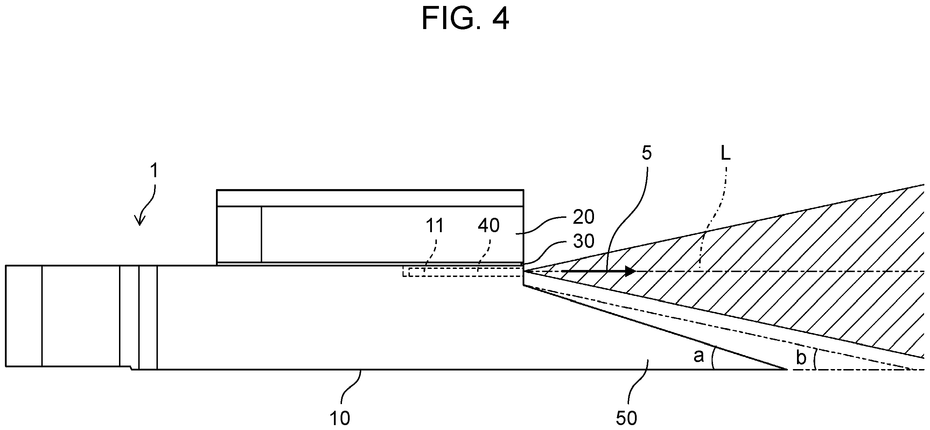

As illustrated also in Fig. 4, the surface, of heat dissipator 50, facing the laser light is inclined such that the surface is more distant from center line L of the laser light toward the forward direction. An inclination angle a of the inclined surface of heat dissipator 50 is greater than a spread angle b of the laser light from the center line L.

If there is no problem in machining and spreading of the radiated laser light, it is possible to provide a step portion for facilitating machining at the root, of the inclined surface of heat dissipator 50, on the light emitting surface side of semiconductor laser element 40.

As a result, it is possible to prevent or reduce blocking, by heat dissipator 50, of the laser light emitted from semiconductor laser element 40 and radially spreading from the light emitting surface.

In the present exemplary embodiment, heat dissipator 50 is provided on first block 10, but heat dissipator 50 may be provided on second block 20. Further, heat dissipator 50 may be provided on both first block 10 and second block 20.

Although the inclination angle a of the inclined surface of heat dissipator 50 is greater than the spread angle b with respect to the center line L of the laser light, the inclination angle a and the spread angle b may be the same angle.

Although will be described later in detail, heat dissipator 50 may lack, in plan view, at least one side in the width direction on the forward side in the emission direction of the laser light.

This makes it possible, when a plurality of laser devices 1 are arranged to combine laser light, to prevent or reduce interference between heat dissipators 50 of neighboring laser devices 1.

It is also possible to relatively effectively dissipate the heat generated in semiconductor laser elements 40 from the central sides of heat dissipators 50.

### «Second exemplary embodiment»

Hereinafter, the same parts as in the first exemplary embodiment will be denoted by the same reference marks, and only the differences will be described.

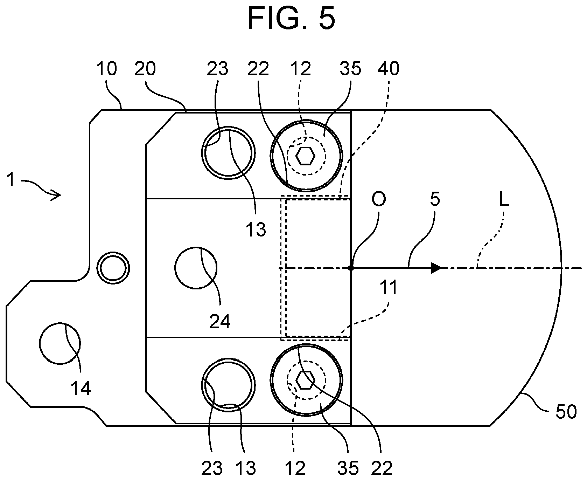

As illustrated in Fig. 5, first block 10 is provided with heat dissipator 50. Heat dissipator 50 is provided at an end part of first block 10 on the emission side of the laser light. Heat dissipator 50 extends forward beyond a light emitting surface of semiconductor laser element 40.

The surface, of heat dissipator 50, facing the laser light is inclined so as to be more distant from center line L of the laser light toward the forward direction. Here, a substantially central part, in plan view, of a front end edge of heat dissipator 50 in the width direction orthogonal to center line L of the laser light protrudes forward beyond the end parts of heat dissipator 50 in the width direction.

In the example illustrated in Fig. 5, the front end edge of heat dissipator 50 is formed, in plan view, in a shape along a concentric circle with the emission position of the laser light on the light emitting surface of semiconductor laser element 40 as the center O. As a result, heat dissipator 50 is formed, in plan view, in a line-symmetric shape with respect to center line L of the laser light.

Such a configuration makes it possible to efficiently dissipate the heat generated in semiconductor laser element 40 from heat dissipator 50.

Specifically, the heat generated in semiconductor laser element 40 is released in a radial shape with the light emitting surface as the center. Therefore, when the front end edge of heat dissipator 50 has, in plan view, a shape along a concentric circle with the emission position of the laser light on the light emitting surface as center O, the area of heat dissipator 50 can be minimized without reducing heat dissipation efficiency.

In addition, when a plurality of laser devices 1 are arranged to combine laser light, it is possible to prevent or reduce interference between heat dissipators 50 of neighboring laser devices 1.

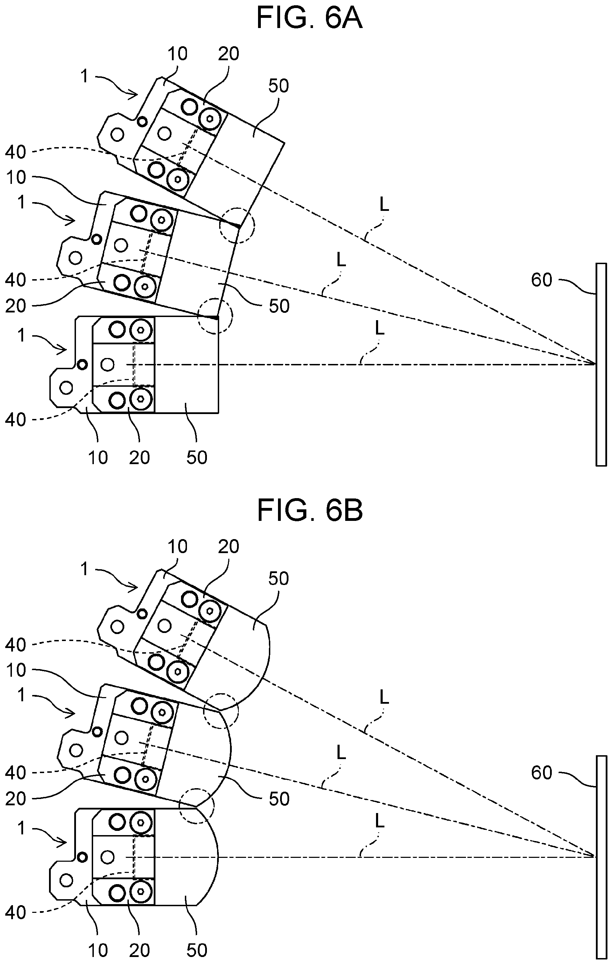

Specifically, a consideration will be given on a case where a plurality of beams of laser light are condensed on diffraction grating 60 to combine the beams as illustrated in Fig. 6A. Instead of diffraction grating 60, a prism may be used.

In the example illustrated in Fig. 6A, heat dissipators 50 are each formed in a quadrangular shape in plan view. In this example, if the plurality of laser devices 1 are arranged such that the incident angles of the laser light beams incident on diffraction grating 60 are different from each other, corner parts of heat dissipators 50 of neighboring laser devices 1 interfere with each other (see the black filled portions in Fig. 6A).

In contrast, in the example illustrated in Fig. 6B, the corner parts of heat dissipators 50 are cut in an arc shape.

Therefore, even if the plurality of laser devices 1 are arranged such that the incident angles of the laser light beams incident on diffraction grating 60 are different from each other, it is possible to avoid interference between heat dissipators 50 of neighboring laser devices 1.

### -First variation of second exemplary embodiment-

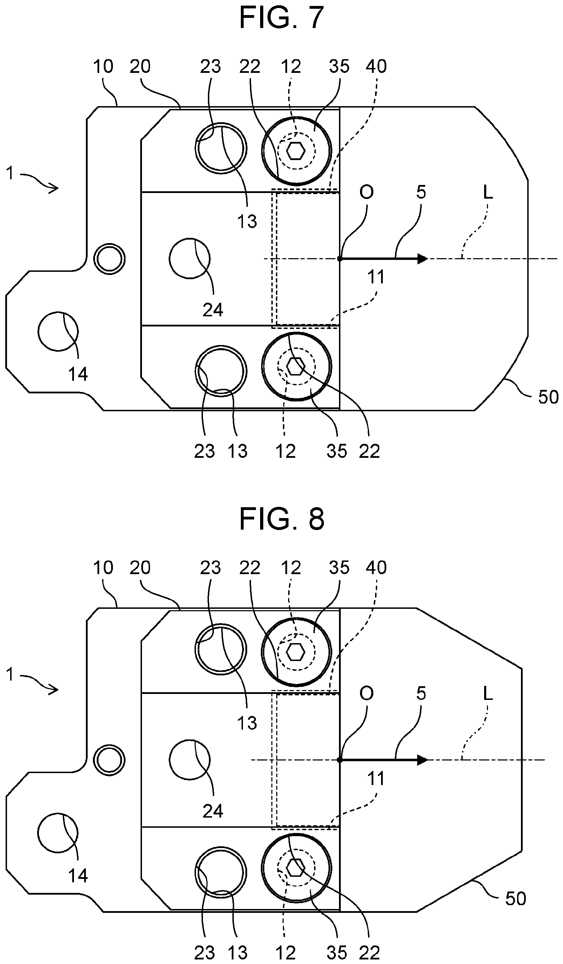

As illustrated in Fig. 7, a substantially central part, in plan view, of the front end edge of heat dissipator 50 in the width direction protrudes forward beyond the end parts of heat dissipator 50 in the width direction. In the example illustrated in Fig. 7, both end parts of heat dissipator 50 in the width direction are formed in an arc shape in plan view. In addition, a central part of heat dissipator 50 in the width direction is linearly cut.

With this configuration, even when there is an obstacle or the like (not illustrated) in front of heat dissipator 50, interference of heat dissipator 50 with the obstacle or the like can be avoided owing to a shape of the cut central part of heat dissipator 50 in the width direction.

### -Second variation of second exemplary embodiment-

As illustrated in Fig. 8, a substantially central part, in plan view, of the front end edge of heat dissipator 50 in the width direction protrudes forward beyond the end parts of heat dissipator 50 in the width direction. In the example illustrated in Fig. 8, both end parts of heat dissipator 50 in the width direction are obliquely cut.

By forming peripheral edge parts of heat dissipator 50 to have a shape in which the peripheral parts are linearly cut as described above, workability is excellent compared with the case of forming the peripheral parts of heat dissipator 50 in an arc shape.

### -Third variation of second exemplary embodiment-

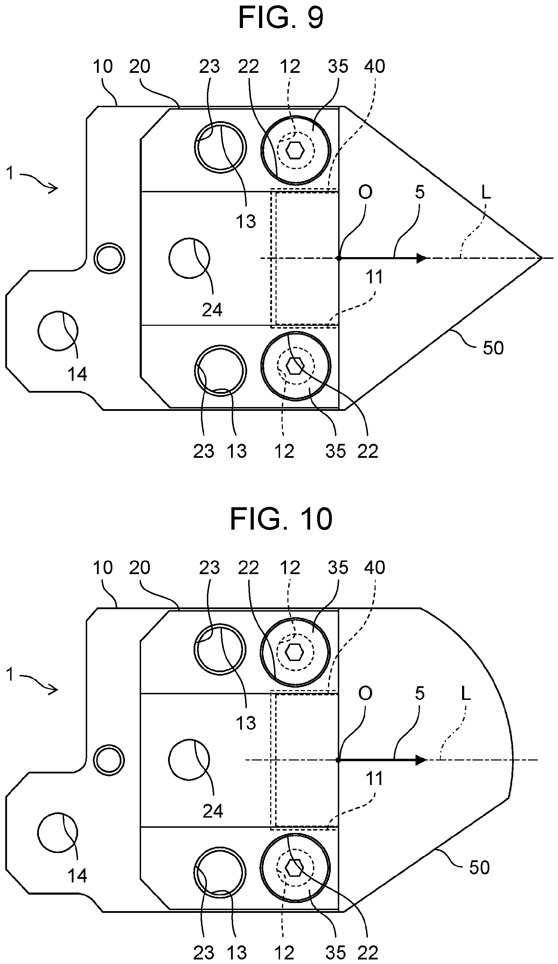

As illustrated in Fig. 9, a substantially central part, in plan view, of the front end edge of heat dissipator 50 in the width direction protrudes forward beyond the end parts of heat dissipator 50 in the width direction. In the example illustrated in Fig. 9, heat dissipator 50 is formed in a triangle in which a substantially central part in the width direction in plan view protrudes forward.

As a result, the heat generated in semiconductor laser element 40 can be efficiently dissipated from a central part, of heat dissipator 50, in the width direction. In addition, by forming peripheral edge parts of heat dissipator 50 in a shape in which the peripheral parts are linearly cut as described above, workability is excellent compared with the case of forming the peripheral parts of heat dissipator 50 in an arc shape.

### «Third exemplary embodiment»

As illustrated in Fig. 10, first block 10 is provided with heat dissipator 50. Heat dissipator 50 is provided at an end part of first block 10 on the emission side of the laser light. Heat dissipator 50 extends forward beyond a light emitting surface of semiconductor laser element 40.

The surface, of heat dissipator 50, facing the laser light is inclined so as to be more distant from center line L of the laser light toward the forward direction. Here, a substantially central part, in plan view, of a front end edge of heat dissipator 50 in the width direction orthogonal to center line L of the laser light protrudes forward beyond the end parts of heat dissipator 50 in the width direction.

In the example illustrated in Fig. 10, a part of the front end edge of heat dissipator 50 is formed, in plan view, in a shape along a concentric circle with the emission position of the laser light on the light emitting surface of semiconductor laser element 40 as center O. A lower corner part of the front end edge of heat dissipator 50 in Fig. 10 is cut linearly with respect to the laser emission direction. As a result, heat dissipator 50 is formed, in plan view, in a non-line-symmetric shape with respect to center line L of the laser light.

With such a configuration, when a plurality of laser devices 1 are arranged to combine laser light, it is possible to prevent or reduce interference between heat dissipators 50 of neighboring laser devices 1.

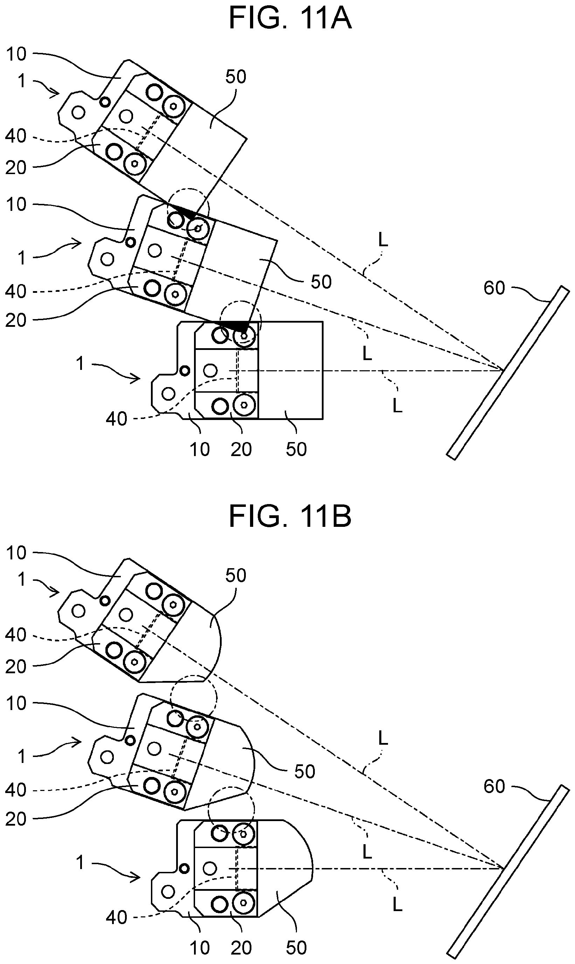

Specifically, a consideration will be given on a case of condensing a plurality of beams of laser light on diffraction grating 60 to combine the beams as illustrated in Fig. 11A. Instead of diffraction grating 60, a prism may be used.

In the example illustrated in Fig. 11A, heat dissipators 50 are formed in a quadrangular shape in plan view. In this case, the plurality of laser devices 1 are arranged such that the incident angles on diffraction grating 60 are different from each other and, at the same time, the distances between laser devices 1 and diffraction grating 60 in the front-back direction are different. However, with such an arrangement, the corner parts of heat dissipators 50 of laser devices 1 each interfere with its neighboring laser device 1 (see the black filled portions in Fig. 11A).

In contrast, in the example illustrated in Fig. 11B, only one corner part (lower corner part in Fig. 11B) of each heat dissipator 50 in the width direction is cut linearly.

Therefore, even if the plurality of laser devices 1 are arranged such that the incident angles on diffraction grating 60 are different from each other and, at the same time, the distances between laser devices 1 and diffraction grating 60 in the front-back direction are different from each other, it is possible to avoid interference between the corner part of each heat dissipator 50 and its neighboring laser device 1.

### -First variation of third exemplary embodiment-

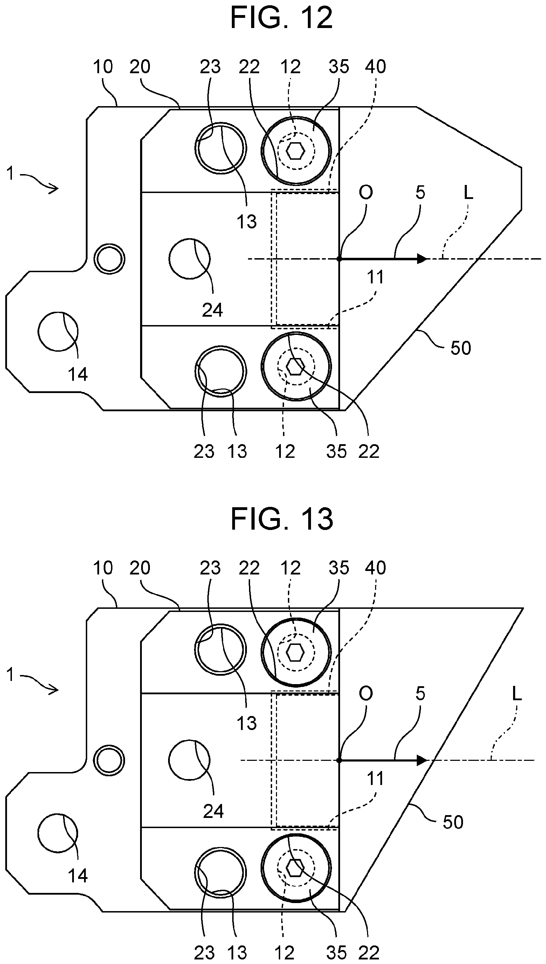

As illustrated in Fig. 12, a substantially central part, in plan view, of the front end edge of heat dissipator 50 in the width direction protrudes forward beyond the end parts of heat dissipator 50 in the width direction.

In the example illustrated in Fig. 12, both end parts of heat dissipator 50 in the width direction are obliquely cut. Here, one end part (lower end part in Fig. 12) of heat dissipator 50 in the width direction has a cut width larger than the cut width of the other end part (upper end part in Fig. 12). As a result, heat dissipator 50 is formed, in plan view, in a non-line-symmetric shape with respect to center line L of the laser light.

By forming peripheral edge parts of heat dissipator 50 to have a shape in which the peripheral parts are linearly cut as described above, workability is excellent compared with the case of forming the peripheral parts of heat dissipator 50 in an arc shape.

### -Second variation of third exemplary embodiment-

As illustrated in Fig. 13, the front end edge of heat dissipator 50 has a shape in which one end part (lower end part in Fig. 13) in the width direction is cut linearly. In the example illustrated in Fig. 13, heat dissipator 50 is formed in a right triangle in which the other end part (upper end part in Fig. 13) in the width direction in plan view protrudes forward. As a result, heat dissipator 50 is formed, in plan view, in a non-line-symmetric shape with respect to center line L of the laser light.

By forming peripheral edge parts of heat dissipator 50 to have a shape in which the peripheral parts are linearly cut as described above, workability is excellent compared with the case of forming the peripheral parts of heat dissipator 50 in an arc shape.

### «Fourth exemplary embodiment»

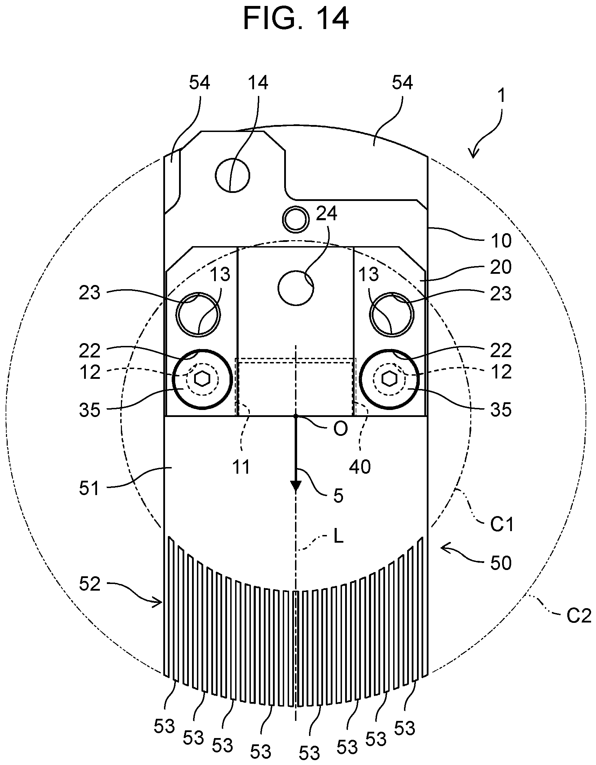

As illustrated in Fig. 14, first block 10 is provided with heat dissipator 50. Heat dissipator 50 includes first heat dissipator 51 and second heat dissipator 52. First heat dissipator 51 is provided at an end part of first block 10 on the emission side of the laser light. First heat dissipator 51 extends forward beyond a light emitting surface of semiconductor laser element 40. Second heat dissipator 52 is provided further forward in emission direction 5 than first heat dissipator 51.

The surfaces, of first heat dissipator 51 and second heat dissipator 52, facing the laser light is inclined so as to be more distant from center line L of the laser light toward the forward direction.

Second heat dissipator 52 has a plurality of fin portions 53 each formed in a plate shape. The plurality of fin portions 53 are arranged at intervals in the plate thickness direction (left-right direction in Fig. 14) of the fin portions 53. The plurality of fin portions 53 are formed by cutting the second heat dissipator 52 to form slit shapes.

By providing the plurality of fin portions 53 in this manner, the surface area of the second heat dissipator 52 can be increased. As a result, the heat generated in semiconductor laser element 40 can be efficiently dissipated from first heat dissipator 51 and second heat dissipator 52.

Here, the front end edge of the first heat dissipator 51, that is, the boundary position between the first heat dissipator 51 and the second heat dissipator 52 is formed, in plan view, in a shape along concentric circle C1 with the emission position of the laser light on the light emitting surface of semiconductor laser element 40 as center O.

Further, the front end edge of second heat dissipator 52 is formed, in plan view, in a shape along concentric circle C2 with the emission position of the laser light on the light emitting surface of semiconductor laser element 40 as center O. The diameter of concentric circle C2 is larger than the diameter of concentric circle C1.

As a result, the heat generated in semiconductor laser element 40 can be efficiently dissipated from first heat dissipator 51 and second heat dissipator 52.

Specifically, the heat generated in semiconductor laser element 40 is released in a radial shape with the light emitting surface as the center. Therefore, when the front end edges of first heat dissipator 51 and second heat dissipator 52 are respectively made to have, in plan view, shapes along concentric circles C1 and C2 with the emission position of the laser light on the light emitting surface as the center, the area of first heat dissipator 51 and second heat dissipator 52 can be minimized without reducing heat dissipation efficiency.

Although, in the example illustrated in Fig. 14, fin portions 53 are configured with plate-shaped fins arranged in the vertical direction, but the surface area of fin portions 53 can be increased also in a case where the fins are arranged in the horizontal direction.

First block 10 is provided with rear heat dissipator 54. Rear heat dissipator 54 is provided at an end part opposite to the emission side of the laser light. Rear heat dissipator 54 extends backward from an end part on the side opposite to the emission side of the laser light. A rear end edge of rear heat dissipator 54 is formed in a shape along concentric circle C2. This can increase the surface area of first block 10.

### INDUSTRIAL APPLICABILITY

As described above, since the present disclosure can provide a high practical effect that it is possible to effectively dissipate the heat generated in a semiconductor laser element, the present disclosure is extremely useful and is highly industrially applicable.

### REFERENCE MARKS IN THE DRAWINGS

- 1: laser device
- 10: first block
- 20: second block
- 40: semiconductor laser element
- 41: anode (first electrode)
- 42: cathode (second electrode)
- 50: heat dissipator
- 51: first heat dissipator
- 52: second heat dissipator
- 53: fin portion
- 54: rear heat dissipator
- C1: concentric circle
- C2: concentric circle
- L: center line

## Claims

1. A laser device comprising:
a semiconductor laser element that emits laser light;
a first block electrically connected to a first electrode of the semiconductor laser element;
a second block electrically connected to a second electrode on an opposite side of the semiconductor laser element with respect to the first electrode, and
a heat dissipator provided on an end part, of at least one of the first block and the second block, on an emission side of the laser light, the heat dissipator extending in a forward direction in an emission direction beyond a light emitting surface of the semiconductor laser element,
wherein
a surface, of the heat dissipator, facing the laser light is an inclined surface that is inclined to be more distant from a center line of the laser light toward the forward direction,
the inclined surface of the heat dissipator has an inclination angle a that is equal to a spread angle b with respect to the center line of the laser light or greater than the spread angle b, and
the heat dissipator has, in plan view, a lacking portion, on at least one side in a width direction, on a forward side in the emission direction of the laser light.

2. The laser device according to Claim 1, wherein the heat dissipator is formed, in plan view, in a line-symmetric shape with respect to the center line of the laser light.

3. The laser device according to Claim 1, wherein the heat dissipator is formed, in plan view, in a non-line-symmetric shape with respect to the center line of the laser light.

4. The laser device according to any one of Claims 1 to 3, wherein a substantially central part, in plan view, of a front end edge of the heat dissipator in a width direction orthogonal to the center line of the laser light protrudes forward beyond end parts, of the front end edge, in the width direction.

5. The laser device according to any one of Claims 1 to 4, wherein
the heat dissipator includes:
a first heat dissipator; and
a second heat dissipator provided further forward in the emission direction than the first heat dissipator, and
the second heat dissipator includes a plurality of fin portions that are each formed in a plate shape and are arranged at intervals in a plate thickness direction.

6. The laser device according to any one of Claims 1 to 5, wherein the front end edge of the heat dissipator is formed, in plan view, in a shape along a concentric circle with an emission position of the laser light on the light emitting surface as a center.

7. The laser device according to any one of Claims 1 to 6, wherein on an end part, of at least one of the first block and the second block, on an opposite side to the emission side of the laser light, a rear heat dissipator that extends backward from the end part on the opposite side is provided.
